(19) Europäisches Patentamt
European Patent Office
Office européen des brevets

(11) **EP 4 675 319 A1**

(12) **EUROPEAN PATENT APPLICATION**
published in accordance with Art. 153(4) EPC


(43) Date of publication:
**07.01.2026 Bulletin 2026/02**

(21) Application number: **24763771.3**

(22) Date of filing: **22.02.2024**

(51) International Patent Classification (IPC):
***G02B 5/02*** *(2006.01)* ***B32B 27/36*** *(2006.01)*
***G02B 1/14*** *(2015.01)* ***G09F 9/00*** *(2006.01)*
***H10K 50/86*** *(2023.01)* ***H10K 59/10*** *(2023.01)*

(52) Cooperative Patent Classification (CPC):
**B32B 27/36; G02B 1/14; G02B 5/02; G09F 9/00; H10K 50/10; H10K 50/86; H10K 59/10; H10K 85/10**

(86) International application number:
**PCT/JP2024/006477**

(87) International publication number:
**WO 2024/181290 (06.09.2024 Gazette 2024/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.02.2023 JP 2023028588**



(71) Applicant: **MITSUBISHI GAS CHEMICAL COMPANY, INC.**
**Chiyoda-ku**
**Tokyo 100-8324 (JP)**

(72) Inventors:
- **KOKUBU, Hiroko**
  **Toyonaka-shi, Osaka 561-0823 (JP)**
- **SUZUKI, Yuto**
  **Toyonaka-shi, Osaka 561-0823 (JP)**
- **TAKASAKI, Masato**
  **Toyonaka-shi, Osaka 561-0823 (JP)**
- **FUKUNAGA, Yasutaka**
  **Tokyo 125-8601 (JP)**

(74) Representative: **Hoffmann Eitle**
**Patent- und Rechtsanwälte PartmbB**
**Arabellastraße 30**
**81925 München (DE)**


(54) **ANTI-GLARE LAMINATE AND PRODUCTION METHOD FOR SAME**


(57) The present invention provides an anti-glare laminate that has, in order, a base material layer that includes at least a polycarbonate resin (a1), a high-hardness resin layer that includes a high-hardness resin (B), and a hard coat layer, wherein the root mean square gradient (Sdq) and the root mean square height (Sq) of the hard coat layer satisfy (i) and (ii), respectively.

$$\text{(i) } 0.010 \leq Sdq \leq 0.10$$

$$\text{(ii) } 0.040 \leq Sq \leq 0.40$$


EP 4 675 319 A1

## Description

TECHNICAL FIELD

The present invention relates to an anti-glare laminate and a method for producing the same. More specifically, the present invention relates to an anti-glare laminate, which has anti-glare performance, high scratch resistance, and excellent shape stability, and which is used as a front protective plate for in-vehicle liquid crystal display devices, mobile phone terminals, personal computers, tablet PCs, etc., and a method for producing the same.

BACKGROUND ART

For the purpose of protecting liquid crystal panels, etc., front plates are provided to liquid crystal display devices. Examples of materials for use in conventional front plates for liquid crystal display devices include (meth)acrylic resins typified by polymethyl methacrylate (PMMA).

In recent years, sheets made of polycarbonate resins have been used as front plates because of having high impact resistance, heat resistance, secondary workability, lightweight properties, transparency, etc. In particular, a front plate that has a hard coat on a multilayer sheet in which an acrylic resin is laminated on the surface layer of a polycarbonate resin sheet has been adopted to a wide range of front plates because it not only has surface hardness and scratch resistance comparable to those of conventional acrylic resins with a hard coat, but also has excellent impact resistance, heat resistance, workability and transparency of polycarbonate resins.

The front plate for liquid crystal display devices having the polycarbonate resin sheet is generally formed together with the acrylic resin by means of a melt extrusion method.

In liquid crystal display devices, an optical laminate for antireflection is generally provided on the outermost surface. Such an optical laminate for antireflection suppresses image reflection or reduces reflectance by light scattering or interference.

As one of optical laminates for antireflection, an anti-glare film, in which an anti-glare layer having an uneven shape is formed on the surface of a transparent base material, is known. The anti-glare film can scatter outside light by the uneven shape of the surface, thereby preventing reduction of visibility due to outside light reflection or image reflection. Further, since this optical laminate is usually placed on the outermost surface of a liquid crystal display device, it is also required to impart hard coat properties thereto so as not to be damaged during handling.

In the case of display surfaces of liquid crystal display devices, organic electroluminescence (EL) display devices, etc., a mixture of fine particles and a binder resin or curable resin is usually applied to a base material to form a fine uneven shape on the surface, thereby preventing regular reflection and preventing image reflection. However, when an uneven shape is provided in order to prevent image reflection, scattering of transmitted light that travels straight increases, making the outlines of pixels unclear and causing blurred characters.

Further, when fine particles are added in order to form surface unevenness, fine particles on the outermost surface fall off and act as an abrasive during a scratch resistance test, resulting in significant reduction in scratch resistance when compared to the case where fine particles are not added, which is not preferred.

Thus, there was no front plate for in-vehicle liquid crystal display devices, mobile phone terminals, personal computers, tablet PCs, etc. which has excellent impact resistance, heat resistance, and anti-glare properties that achieve a balance between prevention of image reflection and suppression of blurred characters, and also has high scratch resistance and excellent shape stability. In Patent Document 1, fine particles are added in order to improve transmission clarity and reduce blurred characters. When fine particles are added, pencil hardness is improved, but scratch resistance is reduced, and therefore it is not preferred.

Patent Document 2 describes an anti-glare laminate having anti-glare performance that achieves a balance between prevention of image reflection and suppression of blurred characters, but claim 1 defines that the haze as defined in JIS K 7136 is at least 15%. When the haze exceeds 15%, it gives a whitish impression when used for in-vehicle liquid crystal display devices, leading to reduction in visibility.

PRIOR ART DOCUMENTS

PATENT DOCUMENTS

Patent Document 1: Japanese Laid-Open Patent Publication No. 2010-160398
Patent Document 2: WO2020/203359

DISCLOSURE OF THE INVENTION

PROBLEMS TO BE SOLVED BY THE INVENTION

The present invention addresses the problem of solving at least one of the above-described conventional problems. The present invention further addresses the problem of providing an anti-glare laminate which has anti-glare performance that achieves a balance between prevention of image reflection and suppression of blurred characters, has high scratch resistance, and has excellent shape stability, and a method for producing the same.

MEANS FOR SOLVING THE PROBLEMS

The above-described problems can be solved by the present invention described below. Specifically, the present invention is as described below.

<1> An anti-glare laminate in which a base material layer that includes at least a polycarbonate resin (a1), a high-hardness resin layer that includes a high-hardness resin (B), and a hard coat layer are arranged in this order, wherein the root mean square gradient (Sdq) and the root mean square height (Sq) of the hard coat layer respectively satisfy (i) and (ii):

$$\text{(i) } 0.010 \leq \text{Sdq} \leq 0.10$$

$$\text{(ii) } 0.040 \leq \text{Sq} \leq 0.40$$

<2> The anti-glare laminate according to item <1>, wherein the root mean square gradient (Sdq) and the root mean square height (Sq) of the hard coat layer respectively satisfy (iii) and (iv):

$$\text{(iii) } 0.035 \leq \text{Sdq} \leq 0.06$$

$$\text{(iv) } 0.20 \leq \text{Sq} \leq 0.35$$

<3> The anti-glare laminate according to item <1> or <2>, wherein the warpage variation of the anti-glare laminate after being held for 120 hours under conditions at a temperature of 85°C and a relative humidity of 85% is 350 μm or less.

<4> The anti-glare laminate according to any one of items <1> to <3>, wherein the high-hardness resin layer has a thickness of 10 to 250 μm.

<5> The anti-glare laminate according to any one of items <1> to <4>, wherein the total thickness of the base material layer and the high-hardness resin layer is 100 to 3,000 μm.

<6> The anti-glare laminate according to any one of items <1> to <5>, wherein the hard coat layer does not contain organic particles or inorganic particles.

<7> The anti-glare laminate according to any one of items <1> to <6>, wherein the polycarbonate resin (a1) includes a component derived from a monovalent phenol represented by general formula (5):

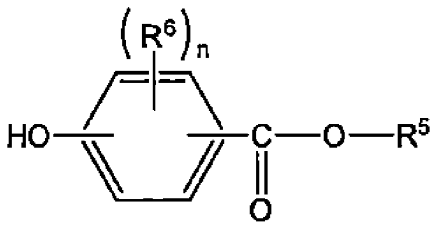 (5)

wherein in the formula, $R^5$ represents a $C_{8-36}$ alkyl group or a $C_{8-36}$ alkenyl group; each $R^6$ independently represents a hydrogen atom, halogen, a $C_{1-20}$ alkyl group which may have a substituent, or a $C_{6-12}$ aryl group which may have a substituent; n is an integer of 0 to 4; and in this regard, the substituent is halogen, a $C_{1-20}$ alkyl group, or a $C_{6-12}$ aryl group.

<8> An in-vehicle display device comprising the anti-glare laminate according to any one of items <1> to <7>.
<9> A touch panel front protective plate comprising the anti-glare laminate according to any one of items <1> to <7>.
<10> A front plate for office automation equipments, portable electronic equipments or televisions comprising the anti-glare laminate according to any one of items <1> to <7>.
<11> A method for producing the anti-glare laminate according to any one of items <1> to <7>, the method comprising the step in which a patterned PET film is pressed onto the surface of the hard coat layer to transfer an uneven shape in a manner such that the hard coat layer after transfer satisfies (i) and (ii):

$$\text{(i) } 0.010 \leq Sdq \leq 0.10$$

$$\text{(ii) } 0.040 \leq Sq \leq 0.40$$

ADVANTAGEOUS EFFECT OF THE INVENTION

According to the present invention, it is possible to provide an anti-glare laminate which has anti-glare performance that achieves a balance between prevention of image reflection and suppression of blurred characters, has high scratch resistance, and has excellent shape stability, and a method for producing the same.

EMBODIMENTS FOR CARRYING OUT THE INVENTION

Hereinafter, the present invention will be described in detail by way of production examples, working examples, etc., but the present invention is not limited thereto and can be arbitrarily changed and then practiced within a range not departing from the gist of the present invention.
In the anti-glare laminate of the present invention, a base material layer that includes at least a polycarbonate resin (a1), a high-hardness resin layer that includes a high-hardness resin (B), and a hard coat layer are arranged in this order.
The order of lamination of the anti-glare laminate is preferably base material layer-high-hardness resin layer-hard coat layer. The other surface of the base material layer is not particularly specified. In one embodiment, the high-hardness resin layer can be provided on the other surface of the base material layer. In this case, the anti-glare laminate has a structure of high-hardness resin layer-base material layer-high-hardness resin layer-hard coat layer. In one embodiment, the high-hardness resin layer and the hard coat layer can be provided on the other surface of the base material layer. In this case, the anti-glare laminate has a structure of hard coat layer-high-hardness resin layer-base material layer-high-hardness resin layer-hard coat layer.
When the high-hardness resin layer is provided on both the surfaces of the base material layer, it is more desirable to use the same high-hardness resin layer on both the surfaces for shape stability. When the hard coat layer is provided on both the surfaces of the base material layer, it is more desirable to provide the same hard coat layer on both the surfaces for better shape stability. Note that the base material layer and the high-hardness resin layer, and the high-hardness resin layer and the hard coat layer, respectively, may be directly laminated or may be laminated via another layer, but preferably, the layers are directly laminated.
In one embodiment, the anti-glare laminate can be used for, for example, an in-vehicle display device such as a car navigation device, a center information display (CID), a rear seat entertainment (RSE) device and a cluster, a touch panel front protective plate, and a front plate for office automation equipments, portable electronic equipments or televisions. Further, for example, the front plate can be used solely as a front plate for liquid crystal display devices, but it may also be used for, for example, a complex front plate in which the front plate is laminated with another substrate of a touch sensor or the like.
Hereinafter, respective components of the anti-glare laminate according to the present invention will be described.

<Base Material Layer>

The base material layer includes a polycarbonate resin (a1). The base material layer may further include an additive, etc.

[Polycarbonate Resin (a1)]

The polycarbonate resin (a1) is not particularly limited as long as it contains a carbonate bond, i.e., a -[O-R-OCO]- unit (wherein R may include an aliphatic group, an aromatic group, or both of the aliphatic group and the aromatic group, and it may have a linear structure or a branched structure) in the main chain of the molecule, but it is particularly preferred to use a polycarbonate resin containing a structural unit of formula (4) below. By using such a polycarbonate resin, a resin laminate having excellent impact resistance can be obtained.

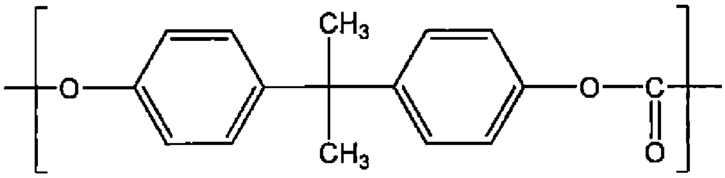 (4)

Specific examples of the polycarbonate resin (a1) include, but are not limited to, aromatic polycarbonate resins (e.g., trade names: Iupilon S-2000, Iupilon S-1000, and Iupilon E-2000, manufactured by Mitsubishi Engineering-Plastics Corporation).

Further, since desire to perform a curving process also on a front plate has been increased in recent years, in the polycarbonate resin (a1), a monovalent phenol represented by general formula (5) below is preferably used as an end terminator.

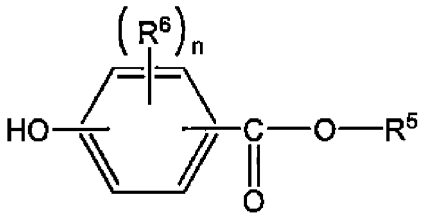 (5)

In the formula, $R^5$ represents a $C_{8-36}$ alkyl group or a $C_{8-36}$ alkenyl group, each $R^6$ independently represents a hydrogen atom, halogen, a $C_{1-20}$ alkyl group which may have a substituent, or a $C_{6-12}$ aryl group which may have a substituent, n is an integer of 0 to 4, and in this regard, the substituent is halogen, a $C_{1-20}$ alkyl group, or a $C_{6-12}$ aryl group. In this specification, the "alkyl group" and the "alkenyl group" may be linear or branched and may have a substituent.

More preferably, the monovalent phenol represented by general formula (5) is represented by general formula (6) below.

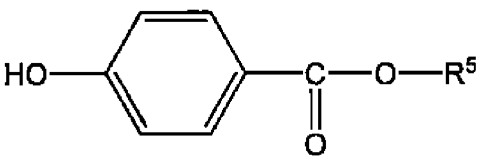 (6)

In the formula, $R^5$ represents a $C_{8-36}$ alkyl group or a $C_{8-36}$ alkenyl group.

The carbon number of $R^5$ in general formula (5) or general formula (6) is more preferably within a specific numerical range. Specifically, the upper limit of the carbon number of $R^5$ is preferably 36, more preferably 22, and particularly preferably 18. Further, the lower limit of the carbon number of $R^5$ is preferably 8, and more preferably 12.

When the upper limit of the carbon number of $R^5$ in general formula (5) or general formula (6) is suitable, it is preferred because the organic solvent solubility of the monovalent phenol (end terminator) tends to be higher and the productivity at the time of the production of the polycarbonate resin is higher.

For example, when the carbon number of $R^5$ is 36 or less, the productivity at the time of the production of the polycarbonate resin is high, and economic efficiency is satisfactory. When the carbon number of $R^5$ is 22 or less, the monovalent phenol is particularly excellent in organic solvent solubility, the productivity at the time of the production of the polycarbonate resin is very high, and economic efficiency is improved.

When the lower limit of the carbon number of $R^5$ in general formula (5) or general formula (6) is suitable, it is preferred because the glass transition point of the polycarbonate resin is not too high and preferable thermoformability is obtained.

For example, when using a monovalent phenol (end terminator) that is a $C_{16}$ alkyl group as $R^5$ in general formula

(6), the glass transition temperature, melt flowability, moldability, drawdown resistance, and the solvent solubility of the monovalent phenol at the time of the production of the polycarbonate resin are excellent, and it is particularly preferred as the end terminator to be used for the polycarbonate resin in the present invention.

Among monovalent phenols (end terminators) represented by general formula (5) or general formula (6), it is particularly preferred to use one or both of p-hydroxybenzoic acid hexadecyl ester and p-hydroxybenzoic acid 2-hexyldecyl ester as the end terminator.

The weight average molecular weight of the polycarbonate resin (a1) is preferably 15,000 to 75,000, more preferably 20,000 to 70,000, and even more preferably 20,000 to 65,000. When the weight average molecular weight of the polycarbonate resin (a1) is 15,000 or more, it is preferred because high impact resistance may be obtained. Meanwhile, when the weight average molecular weight is 75,000 or less, it is preferred because the base material layer can be formed with a small heat source and thermal stability can be maintained even under high-temperature molding conditions. In this specification, the weight average molecular weight is a standard polystyrene equivalent weight average molecular weight measured by gel permeation chromatography (GPC).

The polycarbonate resin (a1) contained in the base material layer may consist of one material or two or more materials.

The content of the polycarbonate resin (a1) in the base material layer is preferably 75% by mass or more, and from the viewpoint of improving impact resistance, more preferably 90% by mass or more, and even more preferably 100% by mass relative to the total mass of the base material layer.

[Additive]

The base material layer may further include an additive.

As the additive, those usually used for anti-glare laminates can be used. Examples of the additive include an antioxidant, an anti-coloring agent, an antistatic agent, a mold release agent, a lubricant, a dye, a pigment, a plasticizer, a flame retardant, a resin modifier, a compatibilizer, and a reinforcing material such as an organic filler and an inorganic filler.

The amount of the additive is preferably 0 to 10% by mass, more preferably 0 to 7% by mass, and particularly preferably 0 to 5% by mass relative to the total mass of the base material layer.

The method for mixing the additive and the resin is not particularly limited, and it is possible to use a method of compounding the total amount, a method of dry-blending a master batch, a method of dry-blending the total amount or the like.

[Constitution of Base Material Layer]

The thickness of the base material layer is preferably 0.1 to 3.5 mm, more preferably 0.3 to 3 mm, and particularly preferably 1.2 to 3 mm.

<High-Hardness Resin Layer>

The high-hardness resin layer includes a high-hardness resin. The high-hardness resin layer may further include an additive, etc. according to need. By providing the high-hardness resin layer between the base material layer and the hard coat layer, an anti-glare laminate having high shape stability can be obtained. Further, the high-hardness resin layer may have, for example, a function of increasing the hardness of the anti-glare laminate. In this specification, the high-hardness resin means a resin having hardness higher than that of the polycarbonate resin serving as the base material and having a pencil hardness of HB or harder, preferably HB to 3H, more preferably H to 3H, and even more preferably 2H to 3H. Note that the pencil hardness of the high-hardness resin layer is a result obtained by evaluation by the pencil scratch hardness test in accordance with JIS K 5600-5-4:1999. Specifically, the highest hardness of the pencil, with which the surface of the high-hardness resin layer is not damaged when the pencil is pressed against the surface at an angle of 45° with respect to the surface with a load of 750 g, while increasing the hardness thereof, is evaluated as the pencil hardness.

[High-Hardness Resin]

The high-hardness resin is not particularly limited, but preferably includes at least one selected from the group consisting of Resin (B1) to Resin (B6). Regarding Resin (B1) to Resin (B6), even in the case of resin compositions containing a plurality of types of resins, such resin compositions may also be referred to as Resin (B1) to Resin (B6).

(Resin (B1))

Resin (B1) is a copolymer resin containing a (meth)acrylic acid ester structural unit (a) represented by general

formula (1) below and an aliphatic vinyl structural unit (b) represented by general formula (2) below. In this regard, the aforementioned Resin (B1) (copolymer resin) may further have another structural unit. Note that the ratio of the total of the (meth)acrylic acid ester structural unit (a) and the aliphatic vinyl structural unit (b) is 90 to 100 mol%, preferably 95 to 100 mol%, and more preferably 98 to 100 mol% relative to all the structural units in the copolymer resin. Further, the ratio of the (meth)acrylic acid ester structural unit (a) is 65 to 80 mol% relative to all the structural units in the copolymer resin. In this specification, (meth)acrylic indicates methacrylic and/or acrylic.

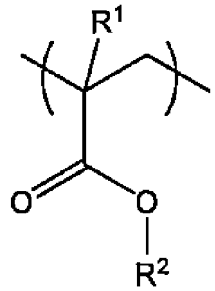

(1)

In the formula, $R^1$ is a hydrogen atom or a methyl group, and preferably a methyl group.

Further, $R^2$ is a $C_{1-18}$ alkyl group, preferably a $C_{1-10}$ alkyl group, and more preferably a $C_{1-6}$ alkyl group. Specific examples thereof include a methyl group, an ethyl group, a butyl group, a lauryl group, a stearyl group, a cyclohexyl group, and an isobornyl group. Among them, $R^2$ is preferably a methyl group or an ethyl group, and more preferably a methyl group.

In the case where $R^2$ is a methyl group or an ethyl group, the (meth)acrylic acid ester structural unit (a) represented by general formula (1) is a (meth)acrylic acid ester structural unit, and in the case where $R^1$ is a methyl group and $R^2$ is a methyl group, the (meth)acrylic acid ester structural unit (a) represented by general formula (1) is a methyl methacrylate structural unit.

As the (meth)acrylic acid ester structural unit (a) represented by general formula (1), only one material may be contained in Resin (B1), or two or more materials may be contained in Resin (B1).

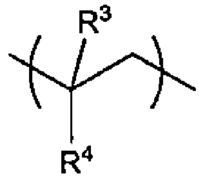

(2)

In the formula, $R^3$ is a hydrogen atom or a methyl group, and preferably a hydrogen atom.

$R^4$ is a cyclohexyl group which may be substituted with a $C_{1-4}$ hydrocarbon group, and preferably a cyclohexyl group not having a substituent. In this specification, the "hydrocarbon group" may be linear, branched or cyclic and may have a substituent.

In the case where $R^3$ is a hydrogen atom and $R^4$ is a cyclohexyl group, the aliphatic vinyl structural unit (b) represented by general formula (2) is a vinylcyclohexane structural unit.

As the aliphatic vinyl structural unit (b) represented by general formula (2), only one material may be contained in Resin (B1), or two or more materials may be contained in Resin (B1).

The aforementioned another structural unit is not particularly limited, and examples thereof include a structural unit derived from an aromatic vinyl monomer including a nonhydrogenated aromatic double bond, which is generated in the process of the production of Resin (B1), wherein: a (meth)acrylic acid ester monomer and an aromatic vinyl monomer are polymerized; and then an aromatic double bond derived from the aromatic vinyl monomer is hydrogenated. Specific examples of said another structural unit include a styrene structural unit.

As said another structural unit, only one material may be contained in Resin (B 1), or two or more materials may be contained in Resin (B 1).

The content of the (meth)acrylic acid ester structural unit (a) represented by general formula (1) is 65 to 80 mol%, and preferably 70 to 80 mol% relative to all the structural units in Resin (B1) (copolymer resin). When the content of the (meth)acrylic acid ester structural unit (a) is 65 mol% or more, a high-hardness resin layer excellent in adhesion to the base material layer and surface hardness can be obtained. Meanwhile, when the content of the (meth)acrylic acid ester structural unit (a) is 80 mol% or less, it is preferred because in this case, warpage caused by water absorption of the anti-glare laminate does not easily occur.

The content of the aliphatic vinyl structural unit (b) represented by general formula (2) is preferably 20 to 35 mol%,

and more preferably 20 to 30 mol% relative to all the structural units in Resin (B1) (copolymer resin). When the content of the aliphatic vinyl structural unit (b) is 20 mol% or more, it is preferred because in this case, warpage under high-temperature and high-humidity conditions can be prevented. Meanwhile, when the content of the aliphatic vinyl structural unit (b) is 35 mol% or less, it is preferred because in this case, detachment from the base material layer at the interface can be prevented.

The content of said another structural unit is preferably 10 mol% or less, more preferably 5 mol% or less, and particularly preferably 2 mol% or less relative to all the structural units in Resin (B1) (copolymer).

In this specification, the "copolymer" may have a structure of either a random copolymer, block copolymer or alternating copolymer.

The weight average molecular weight of Resin (B1) is not particularly limited, but it is preferably 50,000 to 400,000, and more preferably 70,000 to 300,000 from the viewpoint of strength and moldability.

The glass transition temperature of Resin (B1) is preferably 110 to 140°C, more preferably 110 to 135°C, and particularly preferably 110 to 130°C. When the glass transition temperature is 110°C or higher, it is preferred because in this case, deformation and cracking of the resin sheet rarely occur under a heat environment or wet heat environment. Meanwhile, when the glass transition temperature is 140°C or lower, it is preferred because in this case, excellent processability is obtained when molding is performed by means of continuous type thermal shaping using a mirror surface roll or shaping roll or batch type thermal shaping using a mirror surface mold or shaping mold. In the present invention, the glass transition temperature is a temperature obtained by carrying out the measurement using a differential scanning calorimeter and 10 mg of a sample at a temperature raising rate of 10°C/min and calculation according to a midpoint method.

Specific examples of Resin (B1) include Optimas 7500 and 6000 (manufactured by Mitsubishi Gas Chemical Company, Inc.). Note that as the above-described Resin (B1), one material may be used solely, or two or more materials may be used in combination.

The method for producing Resin (B1) is not particularly limited, but it is preferably obtained by polymerizing at least one (meth)acrylic acid ester monomer and at least one aromatic vinyl monomer, followed by hydrogenating an aromatic double bond derived from the aromatic vinyl monomer.

The aforementioned aromatic vinyl monomer is not particularly limited, and examples thereof include styrene, α-methylstyrene, p-hydroxystyrene, alkoxystyrene, chlorostyrene, and derivatives thereof. Among them, styrene is preferred as the aromatic vinyl monomer.

For polymerizing the (meth)acrylic acid ester monomer and the aromatic vinyl monomer, an already-known method can be used. For example, the production can be carried out according to a bulk polymerization method, a solution polymerization method or the like.

The bulk polymerization method is carried out, for example, by a method of continuously supplying a monomer composition containing the above-described monomers and a polymerization initiator to a complete mixing tank to perform continuous polymerization at 100 to 180°C. The above-described monomer composition may contain a chain transfer agent according to need.

The polymerization initiator is not particularly limited, and examples thereof include organic peroxides such as t-amyl peroxy-2-ethylhexanoate, t-butyl peroxy-2-ethylhexanoate, benzoyl peroxide, 1,1-di(t-hexylperoxy)-3,3,5-trimethylcyclohexane, 1,1-di(t-hexylperoxy)cyclohexane, 1,1-di(t-butylperoxy)cyclohexane, t-hexyl propoxyisopropyl monocarbonate, t-amyl peroxy-n-octoate, t-butyl peroxyisopropyl monocarbonate and di-t-butyl peroxide, and azo compounds such as 2,2'-azobisisobutyronitrile, 2,2'-azobis(2-methylbutyronitrile) and 2,2'-azobis(2,4-dimethylvaleronitrile). These substances may be used solely, or two or more of them may be used in combination.

The chain transfer agent is not particularly limited, and examples thereof include α-methylstyrene dimer.

Examples of the solvent to be used in the solution polymerization method include hydrocarbon-based solvents such as toluene, xylene, cyclohexane and methylcyclohexane; ester-based solvents such as ethyl acetate and methyl isobutyrate; ketone-based solvents such as acetone and methyl ethyl ketone; ether-based solvents such as tetrahydrofuran and dioxane; and alcohol-based solvents such as methanol and isopropanol. These solvents may be used solely, or two or more of them may be used in combination.

The solvent to be used in the hydrogenation reaction after the polymerization of the (meth)acrylic acid ester monomer and the aromatic vinyl monomer may be the same as or different from the aforementioned polymerization solvent. Examples thereof include hydrocarbon-based solvents such as cyclohexane and methylcyclohexane, ester-based solvents such as ethyl acetate and methyl isobutyrate, ketone-based solvents such as acetone and methyl ethyl ketone, ether-based solvents such as tetrahydrofuran and dioxane, and alcohol-based solvents such as methanol and isopropanol.

After the (meth)acrylic acid ester monomer and the aromatic vinyl monomer are polymerized as described above, an aromatic double bond derived from the aromatic vinyl monomer is hydrogenated to obtain Resin (B 1).

The method for hydrogenation is not particularly limited, and an already-known method can be used. For example, hydrogenation can be performed at a hydrogen pressure of 3 to 30 MPa and a reaction temperature of 60 to

250°C by means of a batch type or continuous flow-type reaction. When the reaction temperature is 60°C or higher, it is preferred because the reaction time is not too long in this case. Meanwhile, when the reaction temperature is 250°C or lower, it is preferred because a side reaction such as cut of a molecular chain and hydrogenation of an ester moiety is not caused or hardly caused in this case.

Examples of the catalyst to be used in the hydrogenation reaction include a solid catalyst in which a metal such as nickel, palladium, platinum, cobalt, ruthenium and rhodium, or an oxide, salt or complex of the metal is carried by a porous carrier such as carbon, alumina, silica, silica-alumina and diatomaceous earth.

By the hydrogenation reaction, 70% or more of the aromatic double bond derived from the aromatic vinyl monomer is preferably hydrogenated. That is, the rate of nonhydrogenation of the aromatic double bond included in the structural unit derived from the aromatic vinyl monomer is preferably less than 30%, more preferably less than 10%, and even more preferably less than 5%. When the rate of nonhydrogenation is less than 30%, it is preferred because a resin having excellent transparency can be obtained in this case. Note that the structural unit of the nonhydrogenated portion may serve as said another structural unit in Resin (B 1).

In the aforementioned Resin (B 1), another resin can be blended within a range in which transparency is not impaired. That is, Resin (B1) is a resin composition containing the above-described copolymer and another resin. Examples of said another resin include methyl methacrylate-styrene copolymer resin, polymethyl methacrylate, polystyrene, polycarbonate, cycloolefin (co)polymer resin, acrylonitrile-styrene copolymer resin, acrylonitrile-butadiene-styrene copolymer resin, and various elastomers.

(Resin (B2))

Resin (B2) contains 35 to 65% by mass, preferably 40 to 60% by mass of the aforementioned Resin (B1), and 35 to 65% by mass, preferably 40 to 60% by mass of a styrene-unsaturated dicarboxylic acid-based copolymer (C). Further, the styrene-unsaturated dicarboxylic acid-based copolymer (C) contains 65 to 90% by mass of a styrene-based structural unit (c1) and 10 to 35% by mass of an unsaturated dicarboxylic acid anhydride structural unit (c2). That is, Resin (B2) is a resin composition containing two or more types of resins.

• Resin (B 1)

As the aforementioned Resin (B1), the above-described one is used. In this regard, as Resin (B 1), one material may be used solely, or two or more materials may be used in combination.

• Styrene-Unsaturated Dicarboxylic Acid-Based Copolymer (C)

The styrene-unsaturated dicarboxylic acid-based copolymer (C) contains a styrene-based structural unit (c1) and an unsaturated dicarboxylic acid anhydride structural unit (c2).

• Styrene-Based Structural Unit (c1)

The styrene-based monomer is not particularly limited, and any already-known styrene-based monomer can be used. Specific examples of the styrene-based monomer include styrene, $\alpha$-methylstyrene, o-methylstyrene, m-methylstyrene, p-methylstyrene, and t-butylstyrene. Among them, styrene is particularly preferred from the viewpoint of compatibility. These styrene-based monomers may be used solely, or two or more of them may be used in combination.

The content of the styrene-based structural unit (c1) is 65 to 90% by mass, and preferably 70 to 85% by mass relative to the total mass of the styrene-unsaturated dicarboxylic acid-based copolymer (C).

• Unsaturated Dicarboxylic Acid Anhydride Structural Unit (c2)

The unsaturated dicarboxylic acid anhydride monomer is not particularly limited, and examples thereof include acid anhydrides of maleic acid, itaconic acid, citraconic acid, aconitic acid, etc. Among them, maleic anhydride is preferred from the viewpoint of compatibility with the styrene-based monomer. These unsaturated dicarboxylic acid anhydride monomers may be used solely, or two or more of them may be used in combination.

The content of the unsaturated dicarboxylic acid anhydride structural unit (c2) is 10 to 35% by mass, and preferably 15 to 30% by mass relative to the total mass of the styrene-unsaturated dicarboxylic acid-based copolymer (C).

Specific examples of the styrene-unsaturated dicarboxylic acid-based copolymer (C) include XIBOND140, XIBOND160, XIRAN SO23110, and XIRAN SO26080 (manufactured by Polyscope). As the styrene-unsaturated dicarboxylic acid-based copolymer (C), these materials may be used solely, or two or more of them may be used in combination.

(Resin (B3))

Resin (B3) contains 55 to 10% by mass of a vinyl-based monomer-containing resin (D) and 45 to 90% by mass of a styrene-unsaturated dicarboxylic acid-based copolymer (E). Further, the styrene-unsaturated dicarboxylic acid-based copolymer (E) contains 50 to 80% by mass of a styrene-based structural unit (e1), 10 to 30% by mass of an unsaturated dicarboxylic acid anhydride structural unit (e2), and 5 to 30% by mass of a vinyl-based structural unit (e3). That is, Resin (B3) is a resin composition containing two or more types of resins.

• Vinyl-Based Monomer-Containing Resin (D)

The vinyl-based monomer-containing resin (D) is not particularly limited, and examples thereof include materials obtained by homopolymerizing a vinyl-based monomer such as acrylonitrile, methacrylonitrile, acrylic acid, methyl acrylate, ethyl acrylate, n-butyl acrylate, 2-ethylhexyl acrylate, methacrylic acid, methyl methacrylate, ethyl methacrylate, n-butyl methacrylate, and 2-ethylhexyl methacrylate. Among them, methyl methacrylate is preferably contained as a structural unit in the vinyl-based monomer-containing resin (D). The vinyl-based monomer-containing resin (D) may be a polymer in which one of the aforementioned structural units is used, or may be a copolymer in which two or more types of the structural units are used in combination.

The weight average molecular weight of the vinyl-based monomer-containing resin (D) is preferably 10,000 to 500,000, and more preferably 50,000 to 300,000.

As the vinyl-based monomer-containing resin (D), one material may be used solely, or two or more materials may be used in combination.

• Styrene-Unsaturated Dicarboxylic Acid-Based Copolymer (E)

The styrene-unsaturated dicarboxylic acid-based copolymer (E) contains a styrene-based structural unit (e1), an unsaturated dicarboxylic acid anhydride structural unit (e2), and a vinyl-based structural unit (e3).

• Styrene-Based Structural Unit (e1)

The styrene-based monomer is not particularly limited, and any already-known styrene-based monomer can be used. Specific examples of the styrene-based monomer include styrene, $\alpha$-methylstyrene, o-methylstyrene, m-methylstyrene, p-methylstyrene, and t-butylstyrene. Among them, styrene is particularly preferred from the viewpoint of compatibility. These styrene-based monomers may be used solely, or two or more of them may be used in combination.

The content of the styrene-based structural unit (e1) is 50 to 80% by mass, and preferably 50 to 75% by mass relative to the total mass of the styrene-unsaturated dicarboxylic acid-based copolymer (E).

• Unsaturated Dicarboxylic Acid Anhydride Structural Unit (e2)

The unsaturated dicarboxylic acid anhydride monomer is not particularly limited, and examples thereof include acid anhydrides of maleic acid, itaconic acid, citraconic acid, aconitic acid, etc. Among them, maleic anhydride is preferred from the viewpoint of compatibility with the vinyl-based monomer. These unsaturated dicarboxylic acid anhydride monomers may be used solely, or two or more of them may be used in combination.

The content of the unsaturated dicarboxylic acid anhydride structural unit (e2) is 10 to 30% by mass, and preferably 10 to 25% by mass relative to the total mass of the styrene-unsaturated dicarboxylic acid-based copolymer (E).

• Vinyl-Based Structural Unit (e3)

The vinyl-based monomer is not particularly limited, and examples thereof include acrylonitrile, methacrylonitrile, acrylic acid, methyl acrylate, ethyl acrylate, n-butyl acrylate, 2-ethylhexyl acrylate, methacrylic acid, methyl methacrylate, ethyl methacrylate, n-butyl methacrylate, and 2-ethylhexyl methacrylate. Among them, methyl methacrylate (MMA) is preferred from the viewpoint of compatibility with the vinyl-based monomer-containing resin (D). These vinyl-based monomers may be used solely, or two or more of them may be used in combination.

The content of the vinyl-based structural unit (e3) is 5 to 30% by mass, and preferably 7 to 27% by mass relative to the total mass of the styrene-unsaturated dicarboxylic acid-based copolymer (E).

The weight average molecular weight of the styrene-unsaturated dicarboxylic acid-based copolymer (E) is preferably 50,000 to 200,000, and more preferably 80,000 to 200,000. When the weight average molecular weight is within the above-described range, it is preferred because good compatibility with the vinyl-based monomer-containing resin (D) is obtained and the effect of improving heat resistance is excellent.

Specific examples of the styrene-unsaturated dicarboxylic acid-based copolymer (E) include, but are not limited to, RESISFY R100, R200 and R310 (manufactured by Denki Kagaku Kogyo K.K.), and DELPET 980N (manufactured by Asahi Kasei Corporation). As the styrene-unsaturated dicarboxylic acid-based copolymer (E), the above-described materials may be used solely, or two or more of them may be used in combination.

(Resin (B4))

Resin (B4) is a resin copolymer (G) containing 5 to 20% by mass of a styrene structural unit, 60 to 90% by mass of a (meth)acrylic acid ester structural unit and 5 to 20% by mass of an N-substituted maleimide structural unit, or an alloy of the resin copolymer (G) and the styrene-unsaturated dicarboxylic acid-based copolymer (E).

• Resin Copolymer (G)

The resin copolymer (G) contains a styrene structural unit, a (meth)acrylic acid ester structural unit, and an N-substituted maleimide structural unit.

• Styrene Structural Unit

The styrene-based monomer is not particularly limited, and any already-known styrene-based monomer can be used. Specific examples of the styrene-based monomer include styrene, α-methylstyrene, o-methylstyrene, m-methylstyrene, p-methylstyrene, and t-butylstyrene. Among them, styrene is particularly preferred from the viewpoint of compatibility. These styrene-based monomers may be used solely, or two or more of them may be used in combination.

The content of the styrene structural unit is 5 to 20% by mass, preferably 5 to 15% by mass, and more preferably 5 to 10% by mass relative to the total mass of Resin (B4) (resin copolymer (G)).

• (Meth)acrylic Acid Ester Structural Unit

The (meth)acrylic acid ester monomer is not particularly limited, and examples thereof include acrylic acid, methyl acrylate, ethyl acrylate, n-butyl acrylate, 2-ethylhexyl acrylate, methacrylic acid, methyl methacrylate, ethyl methacrylate, n-butyl methacrylate, and 2-ethylhexyl methacrylate. Among them, methyl methacrylate is preferred. These (meth)acrylic acid ester monomers may be used solely, or two or more of them may be used in combination.

The content of the (meth)acrylic acid ester structural unit is 60 to 90% by mass, preferably 70 to 90% by mass, and more preferably 80 to 90% by mass relative to the total mass of Resin (B4) (resin copolymer (G)).

• N-Substituted Maleimide Structural Unit

The N-substituted maleimide monomer is not particularly limited, and examples thereof include N-arylmaleimide such as N-phenylmaleimide, N-chlorophenylmaleimide, N-methylphenylmaleimide, N-naphthylmaleimide, N-hydroxyphenylmaleimide, N-methoxyphenylmaleimide, N-carboxyphenylmaleimide, N-nitrophenylmaleimide, and N-tribromophenylmaleimide. Among them, N-phenylmaleimide is preferred from the viewpoint of compatibility with the (meth)acrylic acid structural unit. These N-substituted maleimide monomers may be used solely, or two or more of them may be used in combination.

The content of the N-substituted maleimide structural unit is 5 to 20% by mass, preferably 5 to 15% by mass, and more preferably 5 to 10% by mass relative to the total mass of Resin (B4) (resin copolymer (G)).

The weight average molecular weight of the resin copolymer (G) is preferably 50,000 to 250,000, and more preferably 100,000 to 200,000.

Specific examples of the resin copolymer (G) include, but are not limited to, DELPET PM120N (manufactured by Asahi Kasei Chemicals Corporation).

The method for producing the resin copolymer (G) is not particularly limited, and it can be produced by means of solution polymerization, bulk polymerization or the like.

• Alloy

The aforementioned alloy is an alloy of the resin copolymer (G) and the styrene-unsaturated dicarboxylic acid-based copolymer (E).

In this regard, it is preferred to make an alloy of the resin copolymer (G) and the styrene-unsaturated dicarboxylic acid-based copolymer (E), wherein both of them have high glass transition temperatures.

The method for producing the alloy is not particularly limited, and examples thereof include a method in which

melt-kneading is performed using a twin screw extruder having a screw diameter of 26 mm and at a cylinder temperature of 240°C and a mixture is extruded into a strand-like shape and pelletized using a pelletizer.

(Resin (B5))

Resin (B5) contains a structural unit (H) represented by formula (3) below. Resin (B5) is preferably a copolymer further containing a structural unit (J) represented by formula (4) below. The copolymer may further contain another structural unit.

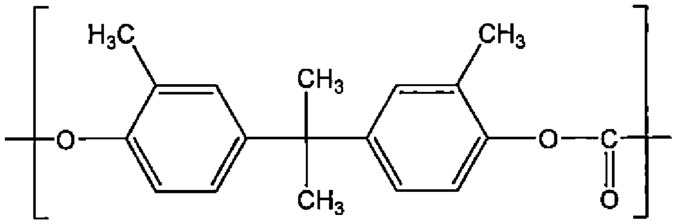
(3)

The content of the structural unit (H) represented by formula (3) is preferably 50 to 100 mol%, more preferably 60 to 100 mol%, and even more preferably 70 to 100 mol% relative to all the structural units in Resin (B5).

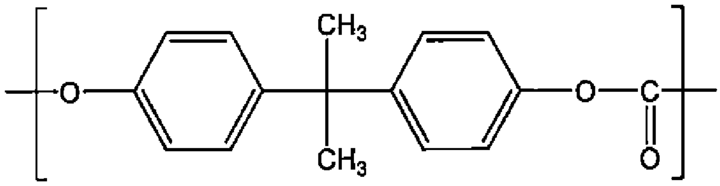
(4)

The content of the structural unit (J) represented by formula (4) is preferably 0 to 50 mol%, more preferably 0 to 40 mol%, and even more preferably 0 to 30 mol% relative to all the structural units in Resin (B5).
The content of said another structural unit is preferably 10 mol% or less, more preferably 5 mol% or less, and particularly preferably 2 mol% or less relative to all the structural units in Resin (B5).
The total content of the structural unit (H) and the structural unit (J) is preferably 90 to 100 mol%, more preferably 95 to 100 mol%, and even more preferably 98 to 100 mol% relative to all the structural units in Resin (B5).
The weight average molecular weight of Resin (B5) is preferably 15,000 to 75,000, more preferably 20,000 to 70,000, and particularly preferably 25,000 to 65,000.
Specific examples of Resin (B5) include, but are not limited to, Iupilon KH3410UR, KH3520UR and KS3410UR (manufactured by Mitsubishi Engineering-Plastics Corporation). As Resin (B5), the above-described materials may be used solely, or two or more of them may be used in combination.
The method for producing Resin (B5) is not particularly limited, but it can be produced by a method similar to the above-described method for producing the polycarbonate resin (a1), except that bisphenol C is used as a monomer.

(Resin (B6))

Resin (B6) contains 35 to 65% by mass of the vinyl-based monomer-containing resin (D) and 35 to 65% by mass of the styrene-unsaturated dicarboxylic acid-based copolymer (C). Further, the styrene-unsaturated dicarboxylic acid-based copolymer (C) contains 65 to 90% by mass of the styrene-based structural unit (c1) and 10 to 35% by mass of the unsaturated dicarboxylic acid anhydride structural unit (c2). That is, Resin (B6) is a resin composition containing two or more types of resins.

• Vinyl-Based Monomer-Containing Resin (D)

As the vinyl-based monomer-containing resin (D), the same materials as those described with respect to Resin (B3) are used. As the vinyl-based monomer-containing resin (D), these materials may be used solely, or two or more of them may be used in combination.

• Styrene-Unsaturated Dicarboxylic Acid-Based Copolymer (C)

As the styrene-unsaturated dicarboxylic acid-based copolymer (C), the same materials as those described with

respect to Resin (B2) are used. As the styrene-unsaturated dicarboxylic acid-based copolymer (C), these materials may be used solely, or two or more of them may be used in combination.

When at least one selected from the group consisting of Resin (B1) to Resin (B6) described above is included as the high-hardness resin, it is preferred because it is possible to obtain an anti-glare laminate that is more excellent in shape stability under high-temperature and high-humidity conditions.

[Additive]

The high-hardness resin layer may include an additive.

The additive is not particularly limited and those usually used for anti-glare laminates can be used. Specific examples of the additive include an antioxidant, an anti-coloring agent, an antistatic agent, a mold release agent, a lubricant, a dye, a pigment, a plasticizer, a flame retardant, a resin modifier, a compatibilizer, and a reinforcing material such as an organic filler and an inorganic filler.

The amount of the additive is preferably 0 to 10% by mass, more preferably 0 to 7% by mass, and particularly preferably 0 to 5% by mass relative to the total mass of the high-hardness resin layer.

The method for mixing the additive and the resin is not particularly limited, and it is possible to use a method of compounding the total amount, a method of dry-blending a master batch, a method of dry-blending the total amount or the like.

[Constitution of High-Hardness Resin Layer]

The thickness of the high-hardness resin layer is preferably 10 to 250 μm, more preferably 30 to 200 μm, and particularly preferably 60 to 150 μm. When the thickness of the high-hardness resin layer is 10 μm or more, it is preferred because high surface hardness is obtained. Meanwhile, when the thickness of the high-hardness resin layer is 250 μm or less, it is preferred because high impact resistance is obtained.

[Layering of High-Hardness Resin Layer on Base Material Layer]

Hereinafter, the case where the high-hardness resin layer is layered on the base material layer will be described, though an additional layer may exist between the base material layer and the high-hardness resin layer as described above.

The total thickness of the base material layer and the high-hardness resin layer is preferably 100 to 3500 μm, more preferably 100 to 3000 μm, even more preferably 500 to 3000 μm, and particularly preferably 1200 to 3000 μm. When the total thickness is 100 μm or more, it is preferred because rigidity of the sheet can be kept. Meanwhile, when the total thickness is 3500 μm or less, it is preferred because it is possible to prevent deterioration of sensitivity of a touch sensor, for example, when a touch panel is provided under the sheet.

The ratio of the thickness of the base material layer in the total thickness of the base material layer and the high-hardness resin layer is preferably 75% to 99%, more preferably 80 to 99%, and particularly preferably 85 to 99%. When the ratio is within the above-described range, a balance between hardness and impact resistance can be achieved.

The method for layering the high-hardness resin layer on the base material layer is not particularly limited. Examples thereof include: a method in which the base material layer and the high-hardness resin layer that are individually formed are stacked and bonded by thermocompression; a method in which the base material layer and the high-hardness resin layer that are individually formed are stacked and bonded by an adhesive; a method in which the base material layer and the high-hardness resin layer are formed by co-extrusion molding; and a method in which the base material layer is subjected to in-mold molding to be integrated with the high-hardness resin layer that is formed in advance. Among them, the method of co-extrusion molding is preferred from the viewpoint of the production cost and productivity.

The method of co-extrusion is not particularly limited. For example, in the case of the feed block system, the high-hardness resin layer is arranged on one surface of the base material layer using a feed block, it is extruded into a sheet shape using a T-die, and then it is passed through a molding roll while cooling, thereby forming a desired layered body. In the case of the multi-manifold system, the high-hardness resin layer is arranged on one surface of the base material layer in a multi-manifold die, it is extruded into a sheet shape, and then it is passed through a molding roll while cooling, thereby forming a desired layered body.

<Hard Coat Layer>

The hard coat layer is not particularly limited, but it is preferably an acrylic hard coat. In this specification, the "acrylic hard coat" means a coating film in which a monomer or oligomer or prepolymer containing a (meth)acryloyl group as a polymerization group is polymerized to form a crosslinked structure. Note that the hard coat layer may further contain a

UV absorber.

Preferably, the hard coat layer does not contain organic particles or inorganic particles. When organic particles and inorganic particles are not contained, scratch resistance can be improved. As described later, when the anti-glare treatment of the hard coat layer is carried out by transform using a mold, a hard coat layer having an uneven shape can be formed without including organic particles and inorganic particles.

The content of the (meth)acrylic monomer is preferably 2 to 98% by mass, more preferably 5 to 50% by mass, and even more preferably 20 to 40% by mass relative to the total mass of the (meth)acrylic monomer, the (meth)acrylic oligomer and the surface modifying agent.

The content of the (meth)acrylic oligomer is preferably 2 to 98% by mass, more preferably 50 to 95% by mass, and even more preferably 60 to 80% by mass relative to the total mass of the (meth)acrylic monomer, the (meth)acrylic oligomer and the surface modifying agent.

The content of the surface modifying agent is preferably 0 to 15% by mass, more preferably 1 to 10% by mass, and even more preferably 2 to 5% by mass relative to the total mass of the (meth)acrylic monomer, the (meth)acrylic oligomer and the surface modifying agent.

When a photopolymerization initiator is contained, the content thereof is preferably 0.001 to 7 parts by mass, more preferably 0.01 to 5 parts by mass, and even more preferably 0.1 to 3 parts by mass relative to 100 parts by mass of the total of the (meth)acrylic monomer, the (meth)acrylic oligomer and the surface modifying agent. In this specification, the photopolymerization initiator indicates a photoradical generator.

[(Meth)acrylic Monomer]

As the (meth)acrylic monomer, those in which a (meth)acryloyl group as a functional group exits in the molecule can be used. Specific examples thereof include a monofunctional monomer, a difunctional monomer, and a trifunctional or higher monomer.

Examples of the monofunctional monomer include (meth)acrylic acid and (meth)acrylic acid ester.

Specific examples of difunctional and/or trifunctional or higher (meth)acrylic monomers include diethylene glycol di(meth)acrylate, dipropylene glycol di(meth)acrylate, tripropylene glycol di(meth)acrylate, 1,6-hexanediol di(meth) acrylate, bisphenol A diglycidyl ether di(meth)acrylate, tetraethylene glycol di(meth)acrylate, neopentylglycol hydroxypivalate diacrylate, neopentylglycol di(meth)acrylate, 1,4-butanediol diacrylate, 1,3-butylene glycol di(meth)acrylate, dicyclopentanyl di(meth)acrylate, polyethylene glycol diacrylate, 1,4-butanediol oligoacrylate, neopentyl glycol oligoacrylate, 1,6-hexanediol oligoacrylate, trimethylol propane tri(meth)acrylate, trimethylol propane ethoxy tri(meth)acrylate, trimethylol propane propoxy tri(meth)acrylate, pentaerythritol tri(meth)acrylate, glyceryl propoxy tri(meth)acrylate, trimethylol propane trimethacrylate, trimethylol propane ethylene oxide adduct triacrylate, glycerin propylene oxide adduct triacrylate, and pentaerythritol tetraacrylate.

The hard coat layer may contain one or two or more (meth)acrylic monomers.

[(Meth)acrylic Oligomer]

Examples of the (meth)acrylic oligomer include a difunctional or higher polyfunctional urethane (meth)acrylate oligomer (hereinafter also referred to as a "polyfunctional urethane (meth)acrylate oligomer"), a difunctional or higher polyfunctional polyester (meth)acrylate oligomer (hereinafter also referred to as a "polyfunctional polyester (meth)acrylate oligomer"), and a difunctional or higher polyfunctional epoxy (meth)acrylate oligomer (hereinafter also referred to as a "polyfunctional epoxy (meth)acrylate oligomer").

Examples of the polyfunctional urethane (meth)acrylate oligomer include: a urethanation reaction product of a (meth)acrylate monomer having at least one (meth)acryloyloxy group and hydroxyl group in one molecule and a polyisocyanate; and a urethanation reaction product of an isocyanate compound that is obtained by reacting a polyol with a polyisocyanate and a (meth)acrylate monomer having at least one (meth)acryloyloxy group and hydroxyl group in one molecule.

Examples of the (meth)acrylate monomer having at least one (meth)acryloyloxy group and hydroxyl group in one molecule to be used in the urethanation reaction include 2-hydroxyethyl (meth)acrylate, 2-hydroxypropyl (meth)acrylate, 2-hydroxybutyl (meth)acrylate, 2-hydroxy-3-phenoxypropyl (meth)acrylate, glycerin di(meth)acrylate, trimethylol propane di(meth)acrylate, pentaerythritol tri(meth)acrylate, and dipentaerythritol penta(meth)acrylate.

Examples of the polyisocyanate to be used in the urethanation reaction include polyisocyanates (di- or tri-) such as hexamethylene diisocyanate, lysine diisocyanate, isophorone diisocyanate, dicyclohexylmethane diisocyanate, tolylene diisocyanate, xylylene diisocyanate, diisocyanates obtained by hydrogenation of an aromatic isocyanate among these isocyanates (e.g., diisocyanates such as hydrogenated tolylene diisocyanate and hydrogenated xylylene diisocyanate), triphenylmethane triisocyanate, and dimethylene triphenyl triisocyanate; and polyisocyanates obtained by multimerization of a diisocyanate.

As the polyol to be used in the urethanation reaction, aromatic, aliphatic and alicyclic polyols, a polyester polyol, a polyether polyol, etc. are generally used.

Usually, examples of the aliphatic and alicyclic polyols include 1,4-butanediol, 1,6-hexanediol, neopentyl glycol, ethylene glycol, propylene glycol, trimethylolethane, trimethylolpropane, dimethylolheptane, dimethylol propionic acid, dimethylol butyric acid, glycerin, and hydrogenated bisphenol A.

Examples of the polyester polyol include those obtained by a dehydration condensation reaction of the above-described polyol and a polycarboxylic acid. Specific examples of the polycarboxylic acid include succinic acid, adipic acid, maleic acid, trimellitic acid, hexahydrophthalic acid, phthalic acid, isophthalic acid, and terephthalic acid. These polycarboxylic acids may be in the form of an anhydride.

Examples of the polyether polyol include polyalkylene glycol and a polyoxyalkylene-modified polyol that is obtained by a reaction of the above-described polyol or a phenol with alkylene oxide.

The polyfunctional polyester (meth)acrylate oligomer is obtained by a dehydration condensation reaction using a (meth)acrylic acid, a polycarboxylic acid, and a polyol. Examples of the polycarboxylic acid to be used in the dehydration condensation reaction include succinic acid, adipic acid, maleic acid, itaconic acid, trimellitic acid, pyromellitic acid, hexahydrophthalic acid, phthalic acid, isophthalic acid, and terephthalic acid. These polycarboxylic acids may be in the form of an anhydride. Further, examples of the polyol to be used in the dehydration condensation reaction include 1,4-butanediol, 1,6-hexanediol, diethylene glycol, triethylene glycol, propylene glycol, neopentyl glycol, dimethylolheptane, dimethylol propionic acid, dimethylol butyric acid, trimethylolpropane, ditrimethylolpropane, pentaerythritol, and dipentaerythritol.

The polyfunctional epoxy (meth)acrylate oligomer is obtained by an addition reaction of a polyglycidyl ether and a (meth)acrylic acid. Examples of the polyglycidyl ether include ethylene glycol diglycidyl ether, propylene glycol diglycidyl ether, tripropylene glycol diglycidyl ether, 1,6-hexanediol diglycidyl ether, and bisphenol A diglycidyl ether.

The hard coat layer may contain one or two or more (meth)acrylic oligomers.

[Surface Modifying Agent]

Examples of the surface modifying agent include those that modify surface performance of the hard coat layer such as a leveling agent, an antistatic agent, a surfactant, a water-repellent oil-repellent agent, inorganic particles, and organic particles.

Examples of the leveling agent include a polyether-modified polyalkylsiloxane, a polyether-modified siloxane, a polyester-modified hydroxyl group-containing polyalkylsiloxane, a polyether-modified polydimethylsiloxane having an alkyl group, a modified polyether, and a silicon-modified acrylic.

Examples of the antistatic agent include a glycerin fatty acid ester monoglyceride, a glycerin fatty acid ester organic acid monoglyceride, a polyglycerin fatty acid ester, a sorbitan fatty acid ester, a cationic surfactant, and an anionic surfactant.

Examples of the surfactant and the water-repellent oil-repellent agent include fluorine-containing surfactants and water-repellent oil-repellent agents such as a fluorine-containing group/lipophilic group-containing oligomer and a fluorine-containing group/hydrophilic group/lipophilic group/UV reactive group-containing oligomer.

Examples of the inorganic particles include silica particles, alumina particles, zirconia particles, silver particles, and glass particles.

Examples of the organic particles include acrylic particles and silicon particles.

The hard coat layer may contain one or two or more surface modifying agents.

[Photopolymerization Initiator]

Examples of the photopolymerization initiator include a monofunctional photopolymerization initiator. Specific examples thereof include: 4-(2-hydroxyethoxy)phenyl(2-hydroxy-2-propyl) ketone [Darocur 2959: manufactured by Merck]; $\alpha$-hydroxy-$\alpha,\alpha'$-dimethylacetophenone [Darocur 1173: manufactured by Merck]; acetophenone-based initiators such as methoxyacetophenone, 2,2'-dimethoxy-2-phenylacetophenone [Irgacure 651], and 1-hydroxy-cyclohexylphenylketone; benzoin ether-based initiators such as benzoin ethyl ether and benzoin isopropyl ether; and other materials including halogenated ketone, acylphosphinoxide and acylphosphonate. These photopolymerization initiators may be used solely, or two or more of them may be used in combination.

[UV Absorber]

Examples of the UV absorber include hydroxyphenyltriazine-based, benzotriazole-based and benzophenone-based UV absorbers. Such UV absorbers may be used solely, or two or more of them may be used in combination.

[Constitution of Hard Coat Layer]

The thickness of the hard coat layer is preferably 1 to 40 μm, and more preferably 2 to 10 μm. When the thickness of the hard coat layer is 1 μm or more, it is preferred because sufficient hardness can be obtained. Meanwhile, when the thickness of the hard coat layer is 40 μm or less, it is preferred because the generation of a crack at the time of the curving process can be suppressed. Note that the thickness of the hard coat layer can be measured by observing the cross section thereof using a microscope or the like and performing the actual measurement from the coating film interface to the surface.

The pencil hardness of the surface of the hard coat layer is preferably HB or harder, more preferably H or harder, even more preferably 2H or harder, and particularly preferably 2H to 3H. Note that the pencil hardness of the hard coat layer is a result obtained by evaluation by the pencil scratch hardness test in accordance with JIS K 5600-5-4:1999. Specifically, the highest hardness of the pencil, with which the surface of the hard coat layer is not damaged when the pencil is pressed against the surface at an angle of 45° with respect to the surface with a load of 750 g, while increasing the hardness thereof, is evaluated as the pencil hardness.

When the hard coat layer has an uneven shape, an anti-glare laminate having excellent anti-glare properties and tactile feel can be obtained. Specifically, the root mean square gradient (Sdq) and the root mean square height (Sq) of the hard coat layer respectively satisfy formulae (i) and (ii) below. In this specification, the root mean square gradient (Sdq) and the root mean square height (Sq) are measured in accordance with ISO 25178-2:2012, as described in the Examples which will be described later.

$$\text{(i) } 0.010 \leq Sdq \leq 0.10$$

$$\text{(ii) } 0.040 \leq Sq \leq 0.40$$

Regarding the aforementioned formula (i), the root mean square gradient (Sdq) is an index of anti-glare properties and correlates with haze. When Sdq exceeds 0.10, light scattering becomes excessive, resulting in whitening and poor texture. Formula (i) more preferably satisfies $0.020 \leq Sdq \leq 0.08$, even more preferably satisfies $0.030 \leq Sdq \leq 0.07$, and particularly preferably satisfies $0.035 \leq Sdq \leq 0.06$.

Regarding the aforementioned formula (ii), the root mean square height (Sq) is an index of anti-glare properties and correlates with image clarity. When Sq exceeds 0.40, light scattering becomes excessive, resulting in whitening and poor texture. Formula (ii) more preferably satisfies $0.050 \leq Sq \leq 0.38$, even more preferably satisfies $0.10 \leq Sq \leq 0.37$, and particularly preferably satisfies $0.20 \leq Sq \leq 0.35$.

<Haze>

The haze of the hard coat layer of the anti-glare laminate of the present invention is preferably 30% or less, more preferably 25% or less, even more preferably 22% or less, and particularly preferably 21%. In this specification, the haze is a value measured using an HR-100 type (manufactured by Murakami Color Research Laboratory Co., Ltd.) in accordance with JIS K 7136:2000.

<Image Clarity>

Examples of the method for evaluating image reflection include reflected image clarity (image clarity) measured at a light incidence angle of 60° based on JIS K7374. There are optical comb widths of 0.125 mm, 0.25 mm, 0.5 mm, 1.0 mm, and 2.0 mm. A narrower optical comb width results in a larger variation in values, whereas a wider optical comb width results in a smaller variation in values. Therefore, the optical comb width is preferably 2.0 mm.

Regarding the reflection clarity measured at a light incidence angle of 60°, a higher value indicates that an image is more likely to be reflected, and a lower value indicates that an image is less likely to be reflected. In the present invention, the reflection clarity can be measured by the method described in the Examples which will be described later.

Regarding the uneven shape in the present invention, in order to achieve a balance between performances with respect to blurred characters and image reflection, the reflection clarity measured at a light incidence angle of 60° using an optical comb having an optical comb width of 2.0 mm is preferably 15% or more, more preferably 40% or more, and particularly preferably 50% or more.

[Method for Forming Hard Coat Layer]

The method for forming the hard coat layer is not particularly limited. For example, it can be formed by applying a

hard coat solution onto a layer that is to be positioned under the hard coat layer (e.g., high-hardness resin layer), followed by performing photopolymerization.

The method of applying the hard coat solution (polymerizable composition, reaction composition) is not particularly limited, and an already-known method can be used. Examples thereof include a spin-coating method, a dipping method, a spraying method, a slide coating method, a bar coating method, a roll coating method, a gravure coating method, a meniscus coating method, a flexographic printing method, a screen printing method, a beat coating method, and a brushing method.

As a lamp to be used for light irradiation at the time of photopolymerization, a lamp having a light emission distribution at a light wavelength of 420 nm or lower is used. Examples thereof include a low-pressure mercury lamp, a medium-pressure mercury lamp, a high-pressure mercury lamp, an ultrahigh pressure mercury lamp, a chemical lamp, a black light lamp, a microwave-excited mercury lamp, and a metal halide lamp. Among them, the high-pressure mercury lamp or metal halide lamp is preferred because it efficiently emits a light in the active wavelength region of the photopolymerization initiator and it does not often emit a short-wavelength light, which reduces viscoelastic properties of a polymer obtained due to crosslinking, or a long-wavelength light, which heats and evaporates a reaction composition.

The irradiation intensity of the above-described lamp is a factor that influences the polymerization degree of the obtained polymer and is suitably controlled depending on every performance of an intended product. When blending a usual cleavage-type photopolymerization initiator having an acetophenone group, the illuminance is preferably 0.1 to 300 $mW/cm^2$. It is particularly preferred that the metal halide lamp is used and that the illuminance is 10 to 40 $mW/cm^2$.

A photopolymerization reaction is inhibited by oxygen in the air or oxygen dissolved in a reactive composition. For this reason, light irradiation is desirably carried out by using a technique that can prevent reaction inhibition caused by oxygen. As one of such techniques, there is a method in which a reactive composition is covered with a film made of polyethylene terephthalate or Teflon to block contact with oxygen and the reactive composition is irradiated with a light through the film. Alternatively, the reactive composition may be irradiated with a light through a light-transmitting window under an inert atmosphere in which oxygen is replaced with an inert gas such as nitrogen gas and carbon dioxide gas.

When light irradiation is carried out under an inert atmosphere, a constant amount of an inert gas is continuously introduced in order to keep the oxygen concentration in the atmosphere at a low level. By this introduction of the inert gas, an air flow is generated on the surface of a reactive composition to cause monomer evaporation. For suppressing the level of monomer evaporation, the airflow velocity of the inert gas, as the velocity relative to a hard coat solution-applied layered body that moves under the inert gas atmosphere, is preferably 1 m/sec or less, and more preferably 0.1 m/sec or less. When the airflow velocity is within the above-described range, monomer evaporation due to the air flow is substantially suppressed.

For the purpose of improving adhesion of the hard coat layer, the coated surface may be subjected to a pretreatment. Examples of the pretreatment include already-known methods such as a sandblasting method, a solvent treatment method, a corona discharge treatment method, a chromic acid treatment method, a flame treatment method, a hot air treatment method, an ozone treatment method, an ultraviolet treatment method, and a primer treatment method using a resin composition.

The method for forming unevenness on the hard coat layer (anti-glare treatment) is not particularly limited, but a method using a mold is preferred. For example, there is a method in which: firstly a high-hardness resin layer, a coating film that is obtained by applying a reactive composition, and a mold are layered in this order; and secondly, the reactive composition is photopolymerized to be released from the mold. The photopolymerized body of the reactive composition (hard coat layer) has, on the surface thereof in contact with the mold, a shape in which the rough surface of the mold is reflected. That is, it is a method in which the anti-glare treatment of the hard coat layer is performed by means of transfer using a mold.

The aforementioned mold is not particularly limited as long as it transmits UV light, and glass, transparent resin, etc. are used. In one embodiment, examples of the mold include a mold in which a transparent film and a transparent resin having a rough surface are laminated. Examples of the transparent film include a PET film. Examples of the transparent resin having a rough surface include an acrylic resin. In this regard, the rough surface of the transparent resin is not particularly limited, and it may be formed by adding particles (organic particles, inorganic particles, etc.) to the transparent resin, or may be formed by etching the transparent resin, or may be formed by printing and curing the transparent resin. The shape of the rough surface is not particularly limited, but from the viewpoint of use for liquid crystal panels, etc., it is preferably a pattern. By controlling the type of the mold to be used (material, haze of surface, thickness, shape, etc.), the amount of particles to be added, etc., the surface (uneven shape) of the hard coat layer can be controlled. In this manner, a hard coat layer that satisfies the above-described formulae (i) and (ii) can be formed. Preferably, a hard coat layer that further satisfies the above-described formulae (iii) and (iv) can be formed.

In the above-described method for forming the hard coat layer, preferably, a patterned PET film is pressed to transfer an uneven shape. That is, according to one embodiment of the present invention, a method for producing an anti-glare laminate is provided. In this case, the production method includes a step of pressing a patterned PET film onto the surface of the hard coat layer to transfer an uneven shape. As the patterned PET film, for example, low sparkling AG films

PF11, PF23, etc. manufactured by Daicel Corporation can be used.

In one example of the method for producing a patterned PET film that is preferably used in the method for producing the anti-glare laminate of the present invention, a coating liquid is applied to a PET (polyethylene terephthalate) film in a manner such that the dry film thickness becomes 1.0 to 4.0 μm, and after dried at 70 to 90°C for 1 to 3 minutes, the film is irradiated with ultraviolet light and cured using a conveyor equipped with a high-pressure mercury lamp with a light source distance of 12 cm and an output of 80 W/cm and at a line speed of 1.0 to 3.0 m/min, thereby producing a patterned PET film.

The coating liquid preferably contains an organic solvent such as methyl ethyl ketone (MEK), an acrylic ultraviolet curable resin, silica fine particles, and a photoinitiator. Regarding the contents of these components, preferably, the content of the organic solvent such as methyl ethyl ketone (MEK) is 70 to 80 parts by mass, the content of the acrylic ultraviolet curable resin is 19 to 29 parts by mass, the content of the silica fine particles (average particle diameter: 3.5 to 5.0 μm) is 0.2 to 1.0 parts by mass, and the content of the photoinitiator is 2.0 to 4.0 parts by mass. This makes it possible to form a hard coat layer that satisfies the above-described formulae (i) and (ii).

<Physical Properties of Anti-Glare Laminate>

In one embodiment, the anti-glare laminate preferably has high shape stability. Specifically, the warpage variation after being held for 120 hours under conditions in which the temperature is set at 85°C and the relative humidity is set at 85% is preferably 350 μm or less, more preferably 250 μm or less, even more preferably 175 μm or less, and particularly preferably 75 μm or less. When the warpage variation is 350 μm or less, it is preferred because it can be suitably used even under high-temperature and high-humidity conditions. Note that high shape stability can be obtained by using a high-hardness resin layer. When the high-hardness resin layer is interposed between the base material layer and the hard coat layer, the shape of the anti-glare laminate is stabilized even under high-temperature and high-humidity conditions. Note that shape stability can also be controlled by suitably changing the materials of the base material layer and the hard coat layer, the difference in glass transition temperature (Tg) and the difference in hardness between the base material layer and the high-hardness resin layer, the difference in glass transition temperature (Tg) and the difference in hardness between the high-hardness resin layer and the hard coat layer, etc.

<Applications>

The anti-glare laminate of the present invention has excellent anti-glare properties and tactile feel, and is therefore used for protective plates or front plates of liquid crystal surfaces, etc. as described above. In one embodiment, an in-vehicle display device including the anti-glare laminate is provided. In another embodiment, a touch panel front protective plate including the anti-glare laminate is provided. In yet another embodiment, a front plate for office automation equipments, portable electronic equipments or televisions is provided.

## EXAMPLES

Hereinafter, working examples of the present invention will be described, but the present invention is not limited thereto.

<Measurement of Surface Roughness>

Using a confocal laser microscope "OLS 5000" manufactured by Olympus Corporation, the root mean square gradient (Sdq) and the root mean square height (Sq) of the uneven surface of the hard coat layer were measured under the following conditions in accordance with ISO 25178-2:2012.

[Root Mean Square Gradient (Sdq)]

Observation conditions

Objective lens: 20x magnification
Acquisition mode: giving priority to accuracy
Measurement area: 645 μm × 645 μm

Analysis conditions

Correction: removing spike noise, removing gradient

[Root Mean Square Height (Sq)]

Observation conditions

Objective lens: 20x magnification
Acquisition mode: giving priority to accuracy
Measurement area: 645 μm × 645 μm

Analysis conditions

Correction: removing spike noise, removing gradient

<Haze>

The haze was calculated using "HM-150N" manufactured by Murakami Color Research Laboratory Co., Ltd. according to the method specified in JIS K 7136:2000.

<Reflection Clarity (Image Clarity)>

Using "ICM 1T" manufactured by Suga Test Instruments Co., Ltd., the measurement was carried out based on JIS K7374 in a manner such that an optical comb was placed so that the flow direction of the anti-glare laminate was parallel to the direction of the optical comb teeth. The reflected image clarity measured at a light incidence angle of 60° using an optical comb having an optical comb width of 2.0 mm was taken as reflection clarity. In the measurement, a black tape (manufactured by 3M Japan Limited, Black Vinyl Tape model number 117BLA) was attached to the back of the uneven surface to suppress backside reflection.

<SW Hardness>

On the hard coat layer having an uneven shape of the anti-glare laminate, steel wool #0000 manufactured by Nippon Steel Wool Co., Ltd. was moved back and forth 15 times under a load of 100 g/cm$^2$ and the degree of damage was evaluated on a 10-point scale by visual observation. It is described as RANK1 to RANK10. The measurement was performed twice, and when the results differed, the range thereof was taken as the measurement result.
RANK 1: no scratches (equivalent to inorganic glass)
RANK 2: 1 to 5 scratches
RANK 3: 6 to 10 scratches
RANK 4: 11 to 15 scratches
RANK 5: 16 to 20 scratches
RANK 6: 21 to 25 scratches
RANK 7: 26 to 30 scratches
RANK 8: 31 to 40 scratches
RANK 9: 41 to 50 scratches (equivalent to polymethacrylic acid)
RANK 10: 51 or more scratches (equivalent to polycarbonate)

<Shape Stability>

The anti-glare laminate was cut to provide a test piece having a size of 100 mm×60 mm. The test piece obtained by cutting was set into a two-point supporting type holder, and it was placed in an environmental testing machine, in which the temperature was set at 23°C and the relative humidity was set at 50%, for 24 hours or more, so that the conditions were adjusted. After that, warpage was measured (before treatment). Next, the test piece was set into the holder, and it was placed in an environmental testing machine, in which the temperature was set at 85°C and the relative humidity was set at

85%, and held in that state for 120 hours. Subsequently, the test piece, together with the holder, was transferred into an environmental testing machine, in which the temperature was set at 23°C and the relative humidity was set at 50%, and it was held in that state for 4 hours. After that, warpage was measured again (after treatment). For the measurement of warpage, a three-dimensional shape measuring device (KS-1000 manufactured by Keyence Corporation) equipped with an electric stage was used, and the test piece taken out was horizontally placed on the measuring device with its protruding side facing upward. Scanning was performed at 1 mm intervals, and a raised portion in the center of the test piece was measured as a warp. The absolute value of the difference between the warp amounts before and after the treatment, i.e.,

|(warp amount after treatment)-(warp amount before treatment)|

was evaluated as shape stability.

[Example 1]

<Laminate>

A synthetic resin laminate was formed using a multilayer extrusion apparatus having a single screw extruder with a screw diameter of 35 mm, a single screw extruder with a screw diameter of 65 mm, a feed block connected to all the extruders, and a T-die connected to the feed block. Optimas 7500 manufactured by Mitsubishi Gas Chemical Company, Inc. as a high-hardness resin (B1) was continuously introduced into the single screw extruder with the screw diameter of 35 mm and extruded at a cylinder temperature of 240°C and a discharge rate of 2.6 kg/hour. Further, a polycarbonate resin (manufactured by Mitsubishi Engineering-Plastics Corporation, trade name: Iupilon S-1000) was continuously introduced into the single screw extruder with the screw diameter of 65 mm and extruded at a cylinder temperature of 280°C and a discharge rate of 50.0 kg/hour. The feed block connected to all the extruders was equipped with distribution pins of two kinds and two layers, and the high-hardness resin (B1) and the polycarbonate resin were introduced thereinto and laminated at 270°C. It was extruded into a sheet shape using the T-die connected to the feed block at 270°C, and using 3 mirror-finished rolls each at 120°C, 130°C and 190°C from the upstream side, it was transferred on the mirror surfaces and cooled, thereby obtaining a laminate of the high-hardness resin (B1) layer (high-hardness resin layer) and the polycarbonate resin layer (base material layer). The thickness of the obtained laminate was 1.0 mm, and the thickness of the high-hardness resin (B1) layer near the center thereof was 60 μm.

Optimas 7500 manufactured by Mitsubishi Gas Chemical Company, Inc. used as the high-hardness resin (B1) is a copolymer resin containing a (meth)acrylic acid ester structural unit (a) represented by general formula (1) above and an aliphatic vinyl structural unit (b) represented by general formula (2) above. In this regard, the ratio of the total of the (meth) acrylic acid ester structural unit (a) and the aliphatic vinyl structural unit (b) is 99 mol% relative to all the structural units in the copolymer resin, and the ratio of the (meth)acrylic acid ester structural unit (a) is 75 mol% relative to all the structural units in the copolymer resin.

<Photocurable Resin Composition (Y-1)>

To 100 parts by mass of a mixture containing 60% by mass of U6HA (hexafunctional urethane acrylate oligomer, manufactured by Shin-Nakamura Chemical Co., Ltd.), 35% by mass of #260 (1,9-nonanediol diacrylate, manufactured by Osaka Organic Chemical Industry Ltd.) and 5% by mass of a fluorine-based leveling agent, 3 parts by mass of photoinitiator I-184 (manufactured by BASF [compound name: 1-hydroxy-cyclohexyl phenyl ketone]) was added to obtain a photocurable resin composition (Y-1).

<Patterned PET Film (Z-1)>

With 81 parts by mass of MEK, 18.8 parts by mass of an acrylic ultraviolet curable resin (solid content: 100%, trade name: Light Acrylate DPE-6A, manufactured by Kyoeisha Chemical Co., Ltd.), 0.2 parts by mass of silica fine particles (NP-30, average particle diameter: 4 μm, manufactured by AGC Si-Tech Co., Ltd.), and 3 parts by mass (external addition) of a photoinitiator (trade name: Omnirad 184, manufactured by IGM Resins) were mixed and stirred to prepare a coating liquid (i). Next, the coating liquid (i) was applied to a PET (polyethylene terephthalate) film in a manner such that the dry film thickness became 1.4 μm, and after dried at 80°C for 2 minutes, the film was irradiated with ultraviolet light and cured using a conveyor equipped with a high-pressure mercury lamp with a light source distance of 12 cm and an output of 80 W/cm and at a line speed of 1.5 m/min, thereby preparing a patterned PET film (Z-1).

On the high-hardness resin (B1) layer of the laminate consisting of the high-hardness resin (B1) layer (high-hardness resin layer) and the polycarbonate resin layer (base material layer), the photocurable resin composition (Y-1) was applied using a bar coater in a manner such that the coating thickness after curing became 5 to 10 μm, and it was covered with the patterned PET film (Z-1) to be pressure-bonded so that the patterned surface of the film was in contact with the applied solution. After that, it was cured by irradiation using a metal halide lamp (20 mW/cm) with a light source

distance of 12 cm for 30 seconds, and the patterned PET film (Z-1) was peeled off, thereby obtaining an anti-glare laminate having an uneven hard coat layer on the high-hardness resin layer (B 1).

[Example 2]

An anti-glare laminate was produced in a manner similar to that in Example 1, except that a high-hardness resin (B3) described below was used instead of the high-hardness resin (B 1).

The high-hardness resin (B3) was prepared as described below. Specifically, 75% by mass of RESISFY R100 (manufactured by Denki Kagaku Kogyo K.K.) was fed as the styrene-unsaturated dicarboxylic acid-based copolymer (E), and 25% by mass of PARAPET HR-L (manufactured by Kuraray Co., Ltd.) that is a methyl methacrylate resin was fed as the vinyl-based monomer-containing resin (D), and mixing was carried out for 30 minutes using a blender. Next, using an extruder having a screw diameter of 26 mm (manufactured by Toshiba Machine Co., Ltd., TEM-26SS, L/D≈40), the mixture was melt-kneaded at a cylinder temperature of 230°C, extruded into a strand-like shape, and pelletized using a pelletizer, thereby obtaining the high-hardness resin (B3). The pelletization operation was stable.

[Example 3]

An anti-glare laminate was produced in a manner similar to that in Example 1, except that a high-hardness resin (B6) described below was used instead of the high-hardness resin (B1).

The high-hardness resin (B6) was prepared as described below. Specifically, 50% by mass of XIBOND160 (manufactured by Polyscope) was fed as the styrene-unsaturated dicarboxylic acid-based copolymer (C), and 50% by mass of PARAPET HR-L (manufactured by Kuraray Co., Ltd.) that is a methyl methacrylate resin was fed as the vinyl-based monomer-containing resin (D), and mixing was carried out for 30 minutes using a blender. Next, using an extruder having a screw diameter of 26 mm (manufactured by Toshiba Machine Co., Ltd., TEM-26SS, L/D≈40), the mixture was melt-kneaded at a cylinder temperature of 230°C, extruded into a strand-like shape, and pelletized using a pelletizer, thereby obtaining the high-hardness resin (B6). The pelletization operation was stable.

[Example 4]

An anti-glare laminate was produced in a manner similar to that in Example 1, except that a patterned PET film (Z-2) described below was used instead of the patterned PET film (Z-1).

<Patterned PET Film (Z-2)>

The patterned PET film (Z-2) was prepared using a coating liquid (ii) described below instead of the coating liquid (i).

With 85 parts by mass of MEK, 14.9 parts by mass of an acrylic ultraviolet curable resin (solid content: 100%, trade name: Light Acrylate DPE-6A, manufactured by Kyoeisha Chemical Co., Ltd.), 0.1 parts by mass of silica fine particles (NP-30, average particle diameter: 4 μm, manufactured by AGC Si-Tech Co., Ltd.), and 3 parts by mass (external addition) of a photoinitiator (trade name: Omnirad 184, manufactured by IGM Resins) were mixed and stirred to prepare the coating liquid (ii).

[Example 5]

An anti-glare laminate was produced in a manner similar to that in Example 1, except that a patterned PET film (Z-3) described below was used instead of the patterned PET film (Z-1).

<Patterned PET Film (Z-3)>

The patterned PET film (Z-3) was prepared using a coating liquid (iii) described below instead of the coating liquid (i).

With 76 parts by mass of MEK, 23.8 parts by mass of an acrylic ultraviolet curable resin (solid content: 100%, trade name: Light Acrylate DPE-6A, manufactured by Kyoeisha Chemical Co., Ltd.), 0.2 parts by mass of silica fine particles (NP-30, average particle diameter: 4 μm, manufactured by AGC Si-Tech Co., Ltd.), and 3 parts by mass (external addition) of a photoinitiator (trade name: Omnirad 184, manufactured by IGM Resins) were mixed and stirred to prepare the coating liquid (iii).

[Example 6]

An anti-glare laminate was produced in a manner similar to that in Example 1, except that a patterned PET film (Z-4) described below was used instead of the patterned PET film (Z-1).

<Patterned PET Film (Z-4)>

The patterned PET film (Z-4) was prepared using a coating liquid (iv) described below instead of the coating liquid (i).

With 71.5 parts by mass of MEK, 27.7 parts by mass of an acrylic ultraviolet curable resin (solid content: 100%, trade name: Light Acrylate DPE-6A, manufactured by Kyoeisha Chemical Co., Ltd.), 0.8 parts by mass of silica fine particles (NP-30, average particle diameter: 4 μm, manufactured by AGC Si-Tech Co., Ltd.), and 3 parts by mass (external addition) of a photoinitiator (trade name: Omnirad 184, manufactured by IGM Resins) were mixed and stirred to prepare the coating liquid (iv).

[Example 7]

An anti-glare laminate was produced in a manner similar to that in Example 1, except that a patterned PET film (Z-5) described below was used instead of the patterned PET film (Z-1).

<Patterned PET Film (Z-5)>

The patterned PET film (Z-5) was prepared using a coating liquid (v) described below instead of the coating liquid (i).

With 80 parts by mass of MEK, 19.9 parts by mass of an acrylic ultraviolet curable resin (solid content: 100%, trade name: Light Acrylate DPE-6A, manufactured by Kyoeisha Chemical Co., Ltd.), 0.1 parts by mass of silica fine particles (NP-30, average particle diameter: 4 μm, manufactured by AGC Si-Tech Co., Ltd.), and 3 parts by mass (external addition) of a photoinitiator (trade name: Omnirad 184, manufactured by IGM Resins) were mixed and stirred to prepare the coating liquid (v).

[Example 8]

An anti-glare laminate was produced in a manner similar to that in Example 1, except that a methyl methacrylate resin PARAPET HR-L (manufactured by Kuraray Co., Ltd., weight average molecular weight: 90,000, pencil hardness: 2H) that is a high-hardness resin was used instead of the high-hardness resin (B 1).

[Comparative Example 1]

An anti-glare laminate was produced in a manner similar to that in Example 1, except that a patterned PET film (Z-6) described below was used instead of the patterned PET film (Z-1).

<Patterned PET Film (Z-6)>

The patterned PET film (Z-6) was prepared using a coating liquid (vi) described below instead of the coating liquid (i).

With 90 parts by mass of MEK, 9.5 parts by mass of an acrylic ultraviolet curable resin (solid content: 100%, trade name: Light Acrylate DPE-6A, manufactured by Kyoeisha Chemical Co., Ltd.), 0.5 parts by mass of silica fine particles (NP-30, average particle diameter: 4 μm, manufactured by AGC Si-Tech Co., Ltd.), and 3 parts by mass (external addition) of a photoinitiator (trade name: Omnirad 184, manufactured by IGM Resins) were mixed and stirred to prepare the coating liquid (vi).

[Comparative Example 2]

An anti-glare laminate was produced in a manner similar to that in Example 1, except that a patterned PET film (Z-7) described below was used instead of the patterned PET film (Z-1).

<Patterned PET Film (Z-7)>

The patterned PET film (Z-7) was prepared using a coating liquid (vii) described below instead of the coating liquid (i).

With 90 parts by mass of MEK, 9.8 parts by mass of an acrylic ultraviolet curable resin (solid content: 100%, trade name: Light Acrylate DPE-6A, manufactured by Kyoeisha Chemical Co., Ltd.), 0.2 parts by mass of silica fine particles (NP-30, average particle diameter: 4 μm, manufactured by AGC Si-Tech Co., Ltd.), and 3 parts by mass (external addition) of a photoinitiator (trade name: Omnirad 184, manufactured by IGM Resins) were mixed and stirred to prepare the coating liquid (vii).

[Comparative Example 3]

An anti-glare laminate was produced in a manner similar to that in Example 1, except that COSMOSHINE A4295 (Z-8) manufactured by Toyobo Co., Ltd. was used as a patterned PET film instead of the patterned PET film (Z-1).

[Comparative Example 4]

An anti-glare laminate was produced in a manner similar to that in Example 1, except that a hard coat layer was formed as described below.

Specifically, with 85 parts by mass of MEK, 15.7 parts by mass of an acrylic ultraviolet curable resin (solid content: 100%, trade name: Light Acrylate DPE-6A, manufactured by Kyoeisha Chemical Co., Ltd.), 0.3 parts by mass of silica fine particles (octylsilane-treated fumed silica, average primary particle diameter: 1.9 μm, trade name: SE6050-SYB, manufactured by Admatechs), and 3 parts by mass of a photoinitiator (trade name: Irgacure 184, manufactured by Toyotsu Chemiplas Corporation) were mixed and stirred to prepare a photocurable composition (Y-2).

On a high-hardness resin layer, the photocurable composition (Y-2) was applied using a bar coater in a manner such that the coating thickness after curing became 1.4 μm, and it was dried at 80°C for 2 minutes. While purging with nitrogen, it was cured by irradiation using a metal halide lamp (20 mW/cm) with a light source distance of 12 cm for 30 seconds to obtain an anti-glare laminate.

The anti-glare laminates obtained in Examples 1 to 8 and Comparative Examples 1 to 4 are shown in Table 1 below.

Table 1

| | High-hardness resin layer | Hard coat layer | Mold |
|---|---|---|---|
| | Type of high-hardness resin | Photocurable composition | Patterned PET film |
| Example 1 | B1 | Y-1 | Z-1 |
| Example 2 | B3 | Y-1 | Z-1 |
| Example 3 | B6 | Y-1 | Z-1 |
| Example 4 | B1 | Y-1 | Z-2 |
| Example 5 | B1 | Y-1 | Z-3 |
| Example 6 | B1 | Y-1 | Z-4 |
| Example 7 | B1 | Y-1 | Z-5 |
| Example 8 | PMMA | Y-1 | Z-1 |
| Comparative Example 1 | B1 | Y-1 | Z-6 |
| Comparative Example 2 | B1 | Y-1 | Z-7 |
| Comparative Example 3 | B1 | Y-1 | Z-8 (A4295) |
| Comparative Example 4 | B1 | Y-2 | Not used |

Further, in Examples 1 to 8 and Comparative Examples 1 to 4, the root mean square gradient (Sdq), root mean square height (Sq), haze, image clarity, SW hardness, and shape stability were evaluated. The obtained results are shown in Table 2 below.

Table 2

| | Hard coat layer | | | | | Anti-glare laminate |
|---|---|---|---|---|---|---|
| | Surface roughness | | Haze (%) | Image clarity (%) | SW hardness | Shape stability (μm) |
| | Sdq | Sq | | | | |
| Example 1 | 0.046 | 0.27 | 4.6 | 27.0 | 1 to 2 | 100 |
| Example 2 | 0.046 | 0.26 | 2.1 | 13.2 | 1 to 2 | 0 |
| Example 3 | 0.043 | 0.28 | 4.6 | 33.0 | 1 to 2 | 100 |
| Example 4 | 0.057 | 0.34 | 6.1 | 26.7 | 1 to 2 | 100 |
| Example 5 | 0.035 | 0.33 | 2.9 | 35.1 | 1 to 2 | 100 |
| Example 6 | 0.071 | 0.19 | 12.1 | 56.6 | 1 to 2 | 100 |
| Example 7 | 0.015 | 0.06 | 1.3 | 90.5 | 1 to 2 | 100 |
| Example 8 | 0.047 | 0.31 | 4.5 | 27.2 | 1 to 2 | 3000 |
| Comparative Example 1 | 0.127 | 0.43 | 27.4 | 18.0 | 1 to 2 | 100 |
| Comparative Example 2 | 0.189 | 0.62 | 34.4 | 31.0 | 1 to 2 | 100 |
| Comparative Example 3 | 0.008 | 0.03 | 0.1 | 100.0 | 1 to 2 | 100 |
| Comparative Example 4 | 0.154 | 0.47 | 19.9 | 21.4 | 5 to 6 | 100 |

As is clear from the results in Table 2, in Examples 1 to 8, Sdq and Sq respectively satisfied formulae (i) and (ii), and therefore it is understood that excellent anti-glare properties were obtained. Further, it was confirmed that excellent shape stability was also obtained in Examples 1 to 7 in which the high-hardness resin (B 1), (B3) or (B6) was used.

On the other hand, in Comparative Examples 1 and 2, Sdq and Sq did not respectively satisfy formulae (i) and (ii), and therefore the haze value was high and the visibility was poor due to excessive light scattering.

In Comparative Example 3, Sdq and Sq did not respectively satisfy formulae (i) and (ii), and therefore the image clarity was high and the anti-glare properties were insufficient.

In Comparative Example 4, Sdq and Sq did not respectively satisfy formulae (i) and (ii), and therefore the haze value was high and the visibility was poor due to excessive light scattering. Further, it was confirmed that the SW hardness was insufficient because silica fine particles were contained in the hard coat layer.

## Claims

**1.** An anti-glare laminate in which a base material layer comprising at least a polycarbonate resin (a1), a high-hardness resin layer comprising a high-hardness resin (B), and a hard coat layer are arranged in this order, wherein a root mean square gradient (Sdq) and a root mean square height (Sq) of the hard coat layer respectively satisfy (i) and (ii):

$$\text{(i) } 0.010 \leq Sdq \leq 0.10$$

$$\text{(ii) } 0.040 \leq Sq \leq 0.40$$

**2.** The anti-glare laminate according to claim 1, wherein the root mean square gradient (Sdq) and the root mean square height (Sq) of the hard coat layer respectively satisfy (iii) and (iv):

$$\text{(iii) } 0.035 \leq Sdq \leq 0.06$$

$$\text{(iv) } 0.20 \leq Sq \leq 0.35$$

**3.** The anti-glare laminate according to claim 1 or 2, wherein a warpage variation of the anti-glare laminate after being held for 120 hours under conditions at a temperature of 85°C and a relative humidity of 85% is 350 μm or less.

**4.** The anti-glare laminate according to any one of claims 1 to 3, wherein the high-hardness resin layer has a thickness of 10 to 250 μm.

**5.** The anti-glare laminate according to any one of claims 1 to 4, wherein a total thickness of the base material layer and the high-hardness resin layer is 100 to 3,000 μm.

**6.** The anti-glare laminate according to any one of claims 1 to 5, wherein the hard coat layer does not contain organic particles or inorganic particles.

**7.** The anti-glare laminate according to any one of claims 1 to 6, wherein the polycarbonate resin (a1) comprises a component derived from a monovalent phenol represented by general formula (5):

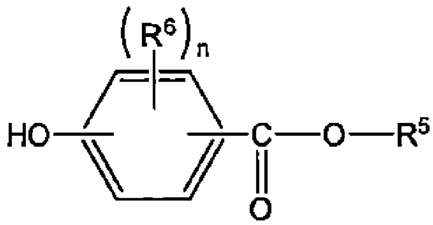 (5)

wherein in the formula, $R^5$ represents a $C_{8-36}$ alkyl group or a $C_{8-36}$ alkenyl group; each $R^6$ independently represents a hydrogen atom, halogen, a $C_{1-20}$ alkyl group which may have a substituent, or a $C_{6-12}$ aryl group which may have a substituent; n is an integer of 0 to 4; and in this regard, the substituent is halogen, a $C_{1-20}$ alkyl group, or a $C_{6-12}$ aryl group.

**8.** An in-vehicle display device comprising the anti-glare laminate according to any one of claims 1 to 7.

**9.** A touch panel front protective plate comprising the anti-glare laminate according to any one of claims 1 to 7.

**10.** A front plate for office automation equipments, portable electronic equipments or televisions comprising the anti-glare laminate according to any one of claims 1 to 7.

**11.** A method for producing the anti-glare laminate according to any one of claims 1 to 7, the method comprising the step in which a patterned PET film is pressed onto a surface of the hard coat layer to transfer an uneven shape in a manner such that the hard coat layer after transfer satisfies (i) and (ii):

$$\text{(i) } 0.010 \leq Sdq \leq 0.10$$

$$\text{(ii) } 0.040 \leq Sq \leq 0.40$$

**INTERNATIONAL SEARCH REPORT**

International application No.
**PCT/JP2024/006477**

**A. CLASSIFICATION OF SUBJECT MATTER**

***G02B 5/02***(2006.01)i; ***B32B 27/36***(2006.01)i; ***G02B 1/14***(2015.01)i; ***G09F 9/00***(2006.01)i; ***H10K 50/86***(2023.01)i; ***H10K 59/10***(2023.01)i
FI: G02B5/02 C; B32B27/36 102; G02B1/14; G09F9/00 313; G09F9/00 338; H10K50/86; H10K59/10

According to International Patent Classification (IPC) or to both national classification and IPC

**B. FIELDS SEARCHED**

Minimum documentation searched (classification system followed by classification symbols)

G02B5/02; B32B27/36; G02B1/14; G09F9/00; H10K50/86; H10K59/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2020/203359 A1 (MITSUBISHI GAS CHEMICAL CO., INC.) 08 October 2020 (2020-10-08)<br>claims, paragraphs [0028]-[0184] | 1-11 |
| Y | WO 2017/150646 A1 (MITSUBISHI GAS CHEMICAL CO., INC.) 08 September 2017 (2017-09-08)<br>claims, paragraphs [0012]-[0136] | 1-11 |
| Y | WO 2017/043538 A1 (NIPPON ELECTRIC GLASS CO., LTD.) 16 March 2017 (2017-03-16)<br>paragraphs [0004], [0005], [0026]-[0046], [0096]-[0106] | 1-11 |
| Y | JP 2021-92693 A (NIPPON ELECTRIC GLASS CO., LTD.) 17 June 2021 (2021-06-17)<br>paragraphs [0002]-[0006], [0029]-[0062] | 1-11 |
| A | US 2021/0300816 A1 (SCHOTT AG) 30 September 2021 (2021-09-30)<br>entire text | 1-11 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 March 2024** | **09 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
PCT/JP2024/006477

C. DOCUMENTS CONSIDERED TO BE RELEVANT

| Category* | Citation of document, with indication, where appropriate, of the relevant passages | Relevant to claim No. |
|---|---|---|
| A | JP 2021-56250 A (AGC INC.) 08 April 2021 (2021-04-08)<br>entire text | 1-11 |

Form PCT/ISA/210 (second sheet) (July 2022)

**INTERNATIONAL SEARCH REPORT**
**Information on patent family members**

International application No.
**PCT/JP2024/006477**

| Patent document cited in search report | Publication date (day/month/year) | Patent family member(s) | Publication date (day/month/year) |
|---|---|---|---|
| WO 2020/203359 A1 | 08 October 2020 | CN 113614585 A<br>TW 202103965 A | |
| WO 2017/150646 A1 | 08 September 2017 | US 2019/0054674 A1<br>claims, paragraphs [0031]-[0250]<br>EP 3425448 A1<br>CN 108700764 A<br>KR 10-2018-0121572 A<br>TW 201801934 A | |
| WO 2017/043538 A1 | 16 March 2017 | US 2018/0251398 A1<br>paragraphs [0004], [0005], [0026]-[0046], [0096]-[0110]<br>EP 3348524 A1<br>CN 107683267 A<br>KR 10-2018-0050606 A<br>TW 201718425 A | |
| JP 2021-92693 A | 17 June 2021 | (Family: none) | |
| US 2021/0300816 A1 | 30 September 2021 | DE 102021107593 A1<br>CN 113461342 A | |
| JP 2021-56250 A | 08 April 2021 | WO 2019/138751 A1 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010160398 A
- WO 2020203359 A